Europäisches Patentamt

European Patent Office

Office européen des brevets

(11) Publication number: **0 451 733 A1**

## EUROPEAN PATENT APPLICATION

(21) Application number: 91105450.0

(22) Date of filing: 06.04.91

(51) Int. Cl.⁵: **G11B 7/125**

(30) Priority: 09.04.90 JP 93507/90

(43) Date of publication of application:
16.10.91 Bulletin 91/42

(84) Designated Contracting States:
CH DE ES FR GB IT LI SE

(71) Applicant: NIPPON CONLUX CO., LTD.
2-2, Uchisaiwai-Cho 2-chome
Chiyoda-ku Tokyo-To(JP)

(72) Inventor: Yamazaki, Koichi
25, Koyama
Sakado-Shi, Saitama-Ken(JP)
Inventor: Nakamura, Eiichi
4-5-7, Nishi-Hashimoto
Sagamihara-Shi, Kanagawa-Ken(JP)

(74) Representative: Reichel, Wolfgang, Dipl.-Ing.
et al
Reichel und Reichel Parkstrasse 13
W-6000 Frankfurt am Main 1(DE)

(54) Method of driving a laser diode for an optical card recording/reproducing apparatus.

(57) There is disclosed a method of driving a laser diode for an optical card recording/reproducing apparatus adapted to irradiate a light beam onto an optical card for carrying out recording of information or reproduction of information, wherein, at the time of reproducing information, the laser diode is caused to be intermittently subjected to emitting operation so that the average output becomes equal to a predetermined value.

FIG. I

EP 0 451 733 A1

## BACKGROUND OF THE INVENTION

This invention relates to a method of driving a laser diode used for recording/reproducing information in an optical card recording/reproducing apparatus.

There are conventionally known media for recording/reproducing information on the basis of the same principle as that of the laser disk or the compact disk. Optical cards of the write-once type are known as the medium in the form of a card.

In the same manner as in the case of disks, such optical cards irradiate a light beam from the laser diode onto the card surface to carry out recording/reproduction of information. Namely, in recording information, a light beam of a large light output of 10 mW or more is irradiated onto the card surface to form information pits. On the other hand, at the time of reproducing information, a light beam of a small light output which is approximately one thirtieth of that at the time of recording, i.e., about 0.5 mW is irradiated to read information pits at the card surface.

In the case of recording/reproduction of information, particularly reproduction, it is pointed out, as the problem peculiar to the card, that the card surface may be damaged or injured. Namely, since both recording and reproduction in the case of the disk is carried out while rotating the disk, there is no possibility that a light beam is excessively and collectively irradiated onto a portion on the disk surface. Accordingly, there is no possibility that the disk surface may be burnt, resulting in damaged record content.

On the contrary, reproduction in the case of the card is carried out while rectilinearly feeding the card in the same manner as that at the time of recording. In the case of rectilinear feed, there may occur any stopped state. If a light beam is irradiated onto a portion of the card surface in the stopped state, the card surface may be burnt even by a small light output, resulting in damaged recorded information.

The cause of this problem is considered as follows. 1) Since a laser diode basically having a large output rating such as 30 mW or 45 mW, etc. is operated in the state of a small output, the operation becomes unstable, so the output of the laser diode may vary in a direction of a large output. 2) If even a laser beam of a small output is continuously irradiated, the accumulated energy may be considerably large.

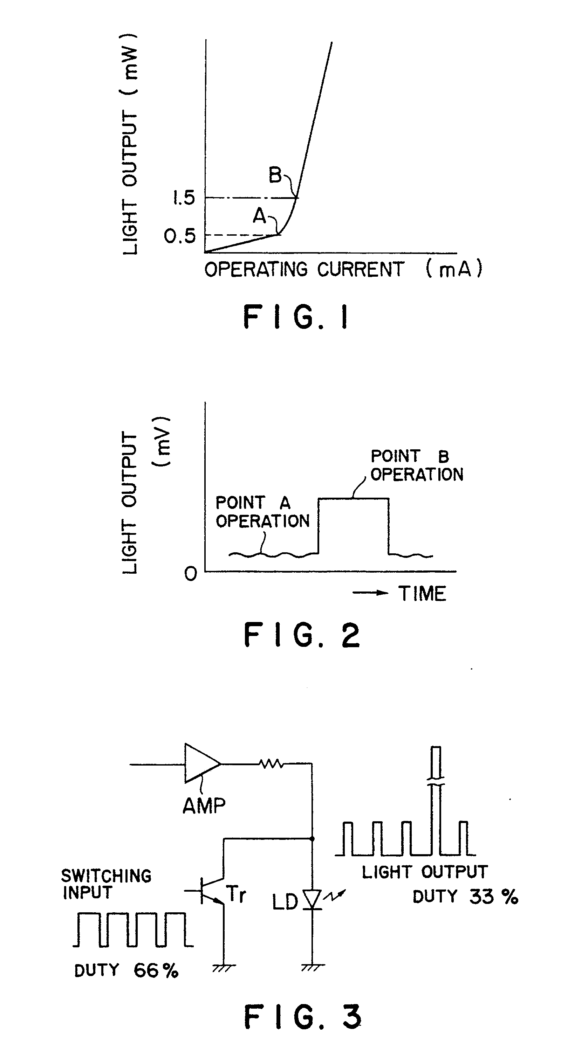

Namely, as shown in FIG. 1, 0.5 mW corresponds to the point A which is the rise point of the operating characteristic curve of the laser diode. At this point, the operating characteristic is apt to change. As a result, as shown in FIG. 2, there occurs a difference between stability when the point A of FIG. 1 is used as the operating point and that when the point B in a stable operating region is used as the operating point.

## SUMMARY OF THE INVENTION

With the above-described points in view, this invention has been made, and its object is to provide a driving method for suitably operating a laser diode so as to permit record information to be reproduced without damaging an optical card.

To achieve the above-described object, this invention provides a method of driving a laser diode for an optical card recording/reproducing apparatus adapted to irradiate a light beam onto an optical card in order to carry out recording or reproduction of information, wherein, at the time of reproducing information the laser diode is intermittently subjected to emitting operation so that the average output becomes equal to a predetermined value.

Even in the case of recording information or in the case of reproducing them, the laser diode must produce a light output of a predetermined value. At the time of recording, the laser diode is continuously operated in the stable operating region. On the other hand, at the time of reproduction, the laser diode is intermittently operated in a low output region of the stable operating region so that the average output becomes equal to a predetermined value.

A required output at the time of recording is 30 times larger than that at the time of reproduction. If an approach is employed to set the peak output at the time of reproduction to a large output of one-to-several times of a required output at the time of recording to carry out an intermittent operation using a duty factor suitably selected, a required output is provided by the average output at the time of reproduction.

Accordingly, when the continuous operation of the prior art is considered to be d.c. operation, the laser diode carries out the a.c. operation by the intermittent operation.

As a result, application of an energy to the laser diode, hence irradiation of optical beam onto the card surface becomes intermittent. Thus, an accumulated energy injection can be prevented.

Since this invention has employed a scheme to intermittently operate the laser diode so that the average output becomes equal to a predetermined value at the time of reproducing information as described above, energization to the laser diode can be carried out in the stable operating region even at the time of reproduction. Thus, information can be reproduced without damaging record information on the optical card. Further, as the result of the fact that the laser diode stably operates, noises due to unstable operations can be prevented.

## BRIEF DESCRIPTION OF THE DRAWINGS

In the accompanying drawings:
FIG. 1 is a characteristic curve showing the operating characteristic of the laser diode;
FIG. 2 is a characteristic curve showing an unstable operation of the laser diode; and
FIG. 3 is a diagram showing a diode drive circuit for applying this invention.

## DESCRIPTION OF THE PREFERRED EMBODIMENT

A method of driving a laser diode of a preferred embodiment according to this invention will now be described with reference to FIG. 1 for a second time.

In this embodiment, a laser diode is operated, e.g., at the point B in the characteristic curve shown in FIG. 1. At the point B, a light output of 1.5 mW is provided. This light output is three times larger than 0.5 mW required for reproduction. By intermittently operating the laser diode at a selected duty ratio of 33 %, the average output of 0.5 mW is provided.

The intermittent operation is carried out at a frequency of, e.g., 20 MHz. When the duty ratio is selected so that it has a large value, the output of the laser diode is further increased. Accordingly, a more stable region of the operating characteristic shown in FIG. 1 can be utilized. However, the intermittent operation in this case would require a higher frequency. This result in the problem of the operation of the circuit in that there occurs the necessity of improving the frequency response characteristic. Further, attention should be also drawn to the fact that the maximum value of the duty factor (ratio) is given when the peak output of the laser diode becomes equal to a rated output.

From the above-mentioned these points, a suitable duty factor is selected.

FIG. 3 shows a laser diode drive circuit for applying this invention. LD denotes a laser diode, and AMP denotes an amplifier for APC (Automatic Power Control). The laser diode LD is energized in response to an output from the amplifier AMP. As a result, this diode LD is emitted. A transistor Tr is connected to the laser diode LD. When a signal of a duty factor of 66% is given as a switching input, the emitting period of the laser diode LD becomes equal to 33% of one cycle. Accordingly, the average emitting output of the laser diode LD is one third of an output when the laser diode is emitted. If the output when the laser diode is emitted is 1.5 mW, the average output becomes equal to 0.5 mW.

In the above description, the light output denotes an optical head output, and is considerably larger than the diode output. For example, 1.5 mW of the optical head output corresponds to 4 mW in terms of the output of the laser diode LD itself.

## Claims

1. A method of driving a laser diode (LD) for an optical card recording/reproducing apparatus adapted to irradiate a light beam onto an optical card for carrying out recording of information or reproduction of information,

   wherein, at the time of reproducing information, said laser diode is caused to be intermittently subjected to emitting operation so that the average output becomes equal to a predetermined value.

2. A method of driving a laser diode for an optical card recording/reproducing apparatus as set forth in claim 1, wherein an output when said laser diode is emitted is caused to be provided in a linear region of the output characteristic curve of said laser diode.

F I G. I

F I G. 2

F I G. 3

## DOCUMENTS CONSIDERED TO BE RELEVANT

EP 91105450.0

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, unexamined applications, P field, vol. 11, no. 19, January 20, 1987 THE PATENT OFFICE JAPANESE GOVERNMENT page 32 P 537 * Kokai-no. 61-192 043 (SHARP CORP.) -- | 1, 2 | G 11 B 7/125 |
| X | PATENT ABSTRACTS OF JAPAN, unexamined applications, P field, vol. 11, no. 164, May 27, 1987 THE PATENT OFFICE JAPANESE GOVERNMENT page 118 P 580 * Kokai-no. 61-296 539 (SHARP CORP.) * ---- | 1, 2 | |

TECHNICAL FIELDS
SEARCHED (Int. Cl.5)

G 11 B 7/00
H 01 S 3/00

The present search report has been drawn up for all claims

| Place of search | Date of completion of the search | Examiner |
|---|---|---|
| VIENNA | 08-07-1991 | BERGER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)